# EUROPEAN PATENT APPLICATION

(11) **EP 4 753 138 A1**
(43) Date of publication of application: **03.06.2026**
(21) Application number: 25213936.5
(22) Date of filing: 06.11.2025
(51) Int. Cl.: H02M 7/5395, H02M 1/08, H02M 1/00, H03K 17/06, H03K 17/14, H03K 17/16, H03K 17/687, H03K 17/73

(54) **IMPROVED NON-LINEAR FLOATING RAIL GENERATION**

(30) Priority: 29.11.2024 US 202418963920
(71) Applicant: STMicroelectronics International N.V., 1228 Plan-les-Ouates, Geneva (CH)
(72) Inventor: SAINI, Pravesh Kumar, 201310 Greater Noida, Uttar Pradesh (IN)
(74) Representative: Buzzi, Notaro & Antonielli d'Oulx S.p.A.

(57) **Abstract**

A floating reference generation circuit for a SMPS includes core biasing, driver logic, and transient biasing blocks. The core biasing block generates temperature and process-tracking reference voltages. The driver logic block uses these references to generate a floating reference voltage through level-shifting and output circuits, with compensation capacitors improving settling time and stability. The transient biasing block employs a diode-transistor cascade and feedback loops to control transitions between voltage levels while maintaining voltage stress limits. The circuit can be configured as either a floating ground generator or floating supply generator through polarity adaptation of the components. Coordination between floating ground and supply reference signals enables precise timing control of voltage transitions. The open-loop architecture enables stable high-speed operation across varying load and line conditions, while eliminating separate reference generation circuits. Implementation provides improved efficiency and noise isolation for analog components while reducing settling time and maintaining high-voltage tolerance.

## Description

### TECHNICAL FIELD

The description relates to power management in integrated circuits. For instance, the description relates to floating rail generation circuits for Switch-Mode Power Supply (SMPS) systems in high-voltage System-on-Chip (SoC) applications.

### BACKGROUND

In modem System-on-Chip (SoC) architectures, the design of efficient and noise-isolated power management systems is of interest. A commonly used component in these systems is the DC-to-DC converter, often implemented as a Switch-Mode Power Supply (SMPS). The performance of these converters directly impacts the overall efficiency and noise characteristics of the SoC.

SMPS designs face several challenges. Noise isolation is a concern, as SMPS circuits generate significant noise that can interfere with sensitive analog components in the SoC. Isolating of this noise is of concern. Additionally, efficiency limitations pose a challenge stemming from the on-resistance of the power transistors. These limitations become more pronounced when operating at higher voltages. Many high-voltage tolerant circuits need to be always-on for reliability reasons, which conflicts with the need for low power consumption in standby modes. Furthermore, SMPS circuits may need to operate over a wide range of input supply voltages, adding another layer of complexity.

Previous solutions have attempted to address these issues through the use of floating supply and ground voltages. As supply voltages increase, reliability concerns arise due to voltage stress on the power transistors. This may necessitate the use of cascodes, adding complexity to the design. Additionally, driving large off-chip capacitances, which can be found in SMPS designs, involves substantial drivers for the power transistors. These drivers must maintain high bandwidth to ensure stable operation, which can further complicate the overall system design. Moreover, to support large transient currents during switching operations, drivers need to have low output impedance. Achieving this while maintaining other performance parameters is challenging.

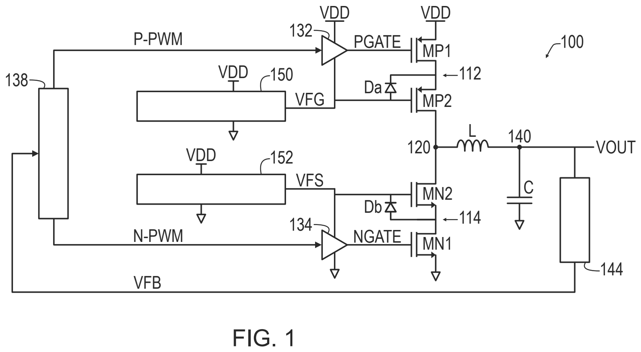

Figure 1 shows an exemplary circuit diagram of a DC-DC voltage converter circuit 100 implemented as a SMPS. The voltage converter circuit 100 includes a bridge including a high side transistor drive circuit 112 and a low side transistor drive circuit 114 coupled in series with each other between a supply voltage node VDD and ground.

The high side transistor drive circuit 112 comprises: a p-channel transistor MP1 having its source connected to VDD and its gate coupled to receive the PGATE signal from a high side driver 132; and a p-channel cascode transistor MP2 having its source connected to the drain of transistor MP1, its drain connected to output node 120, and its gate coupled to receive the floating ground signal VFG from floating ground generator circuit 150. A diode Da has its anode connected to the gate of MP2 and its cathode connected to the node between the drain of transistor MP1 and the source of transistor MP2. The high side gate driver circuit 132 is powered between supply voltage VDD and floating ground voltage VFG, and functions to level shift the pulse width modulation (PWM) control signal P-PWM to generate the high side drive signal PGATE having a voltage range between the floating ground voltage VFG and the supply voltage VDD. The floating ground voltage generator circuit 150 is powered between the supply voltage VDD and ground, and is a variable voltage generator where the level of the floating ground voltage VFG that is generated is dependent on the levels of the supply voltage VDD and ground.

The low side transistor driver circuit 114 comprises: an n-channel cascode transistor MN2 having its drain connected to output node 120 and its gate coupled to receive the floating supply voltage VFS from floating supply generator circuit 152; and an n-channel transistor MN1 having its drain connected to the source of transistor MN2, its source connected to ground, and its gate coupled to receive the NGATE signal from a low side driver 134. A diode Db has its anode connected to the node between the drain of transistor MN2 and transistor MN1 and its cathode connected to the gate of transistor MN2. The low side gate driver circuit 134 is powered between the floating supply voltage VFS and ground, and functions to level shift the PWM control signal N-PWM to generate the low side drive signal NGATE having a voltage range between ground and the floating supply voltage VFS. The floating supply voltage generator circuit 152 is powered between supply voltage VDD and ground, and is a variable voltage generator where the level of the floating supply voltage VFS that is generated is dependent on the levels of the supply voltage VDD and ground.

A PWM control circuit 138 generates non-overlapping PWM control signals P-PWM and N-PWM that are applied, respectively, to the inputs of the high side gate driver 132 and the low side gate driver 134 which then output the high side drive signal PGATE and the low side drive signal NGATE.

In this implementation of the DC-DC voltage converter 100 circuit 100 as a buck converter, an inductor L has its first terminal connected to the switched output node 120 and a second terminal connected to a DC output node 140 where an output voltage VOUT is generated and applied to a load (represented by capacitor C). The output voltage VOUT is sensed by a voltage sensing circuit 144 to generate a feedback voltage VFB. The PWM control circuit 138 uses the feedback voltage VFB to control the pulse widths of the non-overlapping PWM control signals P-PWM and N-PWM and thus regulate the level of the output voltage VOUT.

However, this implementation suffers from limited driving capability, resulting in extended settling times and restricted maximum operating frequency of the SMPS. Additionally, the floating ground and floating supply generator circuits 150 and 152 are constrained by finite output impedance, which degrades the driving capability and settling time of the floating ground voltage VFG and floating supply voltage VFS.

There is a need for an improved approach that can overcome these limitations, providing enhanced efficiency, noise isolation, and reliability in high-voltage SMPS designs for modem SoC architectures. Further development is required to address these challenges.

### SUMMARY

A floating ground generation circuit includes a core biasing circuit that generates first and second reference voltages; a driver logic circuit coupled to the core biasing circuit that generates a floating ground voltage based on the first and second reference voltages; and a transient biasing circuit coupled to the driver logic circuit that controls transitions of the floating ground voltage between voltage levels. The driver logic circuit receives a floating supply reference signal and the transient biasing circuit generates a floating ground reference signal, where the floating supply reference signal and floating ground reference signal are coordinated to control timing of the transitions between voltage levels.

The core biasing circuit may include a voltage divider coupled between a supply voltage and ground to generate the first reference voltage, and a threshold voltage generator coupled to the supply voltage to generate the second reference voltage that tracks process and temperature variations. The voltage divider may include a first resistor connected between the supply voltage and a first node, and a second resistor connected between the first node and ground, where the first reference voltage is generated at the first node. The threshold voltage generator may include a third resistor connected between the supply voltage and a second node, and an n-channel transistor having its drain and gate connected to the second node, and its body connected to its source, where the second reference voltage is generated at the second node.

The driver logic circuit may include a level shifting circuit that generates an intermediate voltage; a floating ground output circuit coupled to the level shifting circuit that generates the floating ground voltage based on the intermediate voltage; and a transient response circuit that controls discharge paths for the floating ground voltage. The floating ground output circuit may include a level-shifting transistor having its gate coupled to receive the second reference voltage and level-shifts between the intermediate voltage and the floating ground voltage; and a pull-down transistor having its gate coupled to receive the intermediate voltage and controls the floating ground voltage.

The driver logic circuit may further include a first capacitor connected between a node carrying the intermediate voltage and ground to filter high-frequency noise, and a second capacitor connected between a supply voltage and a node carrying the floating ground voltage to provide high-frequency decoupling.

The transient biasing circuit may include a diode-transistor cascade circuit that generates the floating ground reference signal that tracks supply voltage variations while maintaining voltage stress limits; a first control path that monitors operating state and adjusts bias conditions; and a feedback loop that regulates current flow during transitions. The diode-transistor cascade circuit may include a first diode having an anode connected to the supply voltage; a second diode having an anode connected to a cathode of the first diode; and a transistor having its drain connected to a cathode of the second diode and its gate coupled to receive the second reference voltage.

The driver logic block may include compensation circuitry that improves output impedance and settling time of the floating ground voltage.

A floating supply voltage generation circuit includes a core biasing block that generates first and second reference voltages; a driver logic block coupled to the core biasing block that generates a floating supply voltage based on the first and second reference voltages; and a transient biasing block coupled to the driver logic block that controls transitions of the floating supply voltage between voltage levels. The driver logic block receives a floating ground reference signal and the transient biasing block generates a floating supply reference signal, where the floating ground reference signal and floating supply reference signal are coordinated to control timing of the transitions between voltage levels.

A DC-DC converter system includes a switching circuit that transfers power between an input and an output; and a floating reference generation circuit that provides a floating reference voltage to the switching circuit. The floating reference generation circuit includes a core biasing block that generates first and second reference voltages; a driver logic block coupled to the core biasing block that generates the floating reference voltage based on the first and second reference voltages; and a transient biasing block coupled to the driver logic block that controls transitions of the floating reference voltage between voltage levels. The driver logic block receives a complementary reference signal and the transient biasing block generates a local reference signal, where the complementary reference signal and local reference signal are coordinated to control timing of the transitions between voltage levels.

### BRIEF DESCRIPTION OF THE DRAWINGS

Figure 1 is a schematic diagram of a prior art Switch-Mode Power Supply (SMPS) implemented as a buck converter with high-side and low-side transistor drive circuits utilizing floating ground and floating supply voltages for level-shifted gate driving.
Figure 2 is a schematic diagram of a floating ground generation circuit disclosed herein such as may be used with the SMPS of Figure 1.
Figure 3 is a schematic diagram of a floating supply generation circuit disclosed herein such as may be used with the SMPS of Figure 1.
Figure 4 includes waveforms showing the floating ground and floating supply voltages generated by the floating ground generation circuit of Figure 2 and floating supply generation circuit of Figure 3.

### DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

Note that in the following description, any resistor or resistance mentioned is a discrete device, unless stated otherwise, and is not simply an electrical lead between two points. Therefore, any resistor or resistance connected between two points has a higher resistance than a lead between those two points, and such resistor or resistance cannot be interpreted as a lead. Similarly, any capacitor or capacitance mentioned is a discrete device, unless stated otherwise, and is not a parasitic element, unless stated otherwise. Additionally, any inductor or inductance mentioned is a discrete device, unless stated otherwise, and is not a parasitic element, unless stated otherwise.

The challenges described above in the prior art are addressed by a floating ground generation circuit 150' and floating supply generation circuit 152' disclosed herein usable with the SMPS 100 of Figure 1.

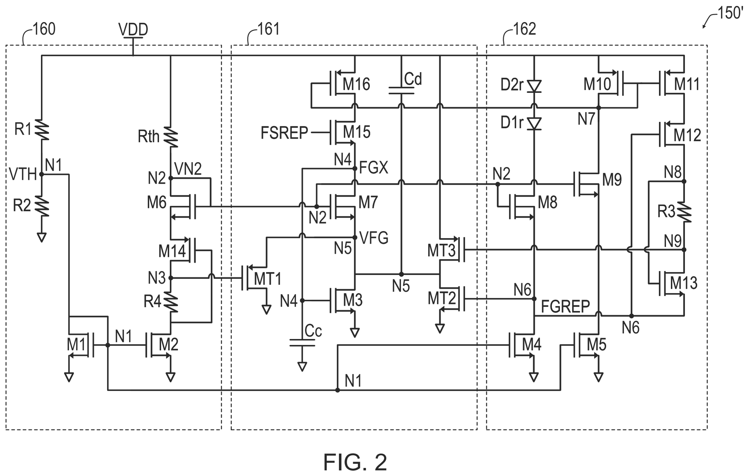

The floating ground generation circuit 150' is now described with reference to Figure 2, and includes a core biasing circuit block 160, driver logic circuit block 161, and transient biasing circuit block 162.

The core biasing circuit block 160 includes: resistor R1 connected between the supply voltage VDD and node N1, and resistor R2 connected between node N1 and ground, with voltage VTH being produced at node N1; resistor Rth connected between supply voltage VDD and node N2, with voltage VN2 being produced at node N2; n-channel transistor M6 having its drain connected to node N2, its gate connected to node N2, and its body connected to its source; p-channel transistor M14 having its source connected to the source of transistor M6 and its drain connected to node N3; n-channel transistor M2 having its drain coupled to node N3 through resistor R4 and to the gate of transistor M14, its source connected to ground, and its gate connected to node N1; and n-channel transistor M1 having its drain and gate connected to node N1, and its source connected to ground.

The driver logic circuit block 161 includes: p-channel transistor M16 having its source connected to supply voltage VDD and its gate connected to node N7; n-channel transistor M15 having its drain connected to the drain of M16, its source connected to node N4, and its gate coupled to receive the signal FSREP, with the voltage FGX being generated at node N4; n-channel transistor M7 having its drain connected to node N4, its source and body connected to node N5, and its gate connected to node N2, with voltage VFG being generated at node N5; n-channel transistor M3 having its drain connected to node N5, its source connected to ground, and its gate connected to node N4; capacitor Cc connected between node N4 and ground; p-channel transistor MT1 having it source connected to node N5, its drain connected to ground, and its gate connected to node N3; capacitor Cd connected between supply voltage VDD and node N5; p-channel transistor MT3 having its source connected to supply voltage VDD, its drain connected to node N5, and its gate connected to node N9; and n-channel transistor MT2 having its drain connected to node N5, its source connected to ground, and its gate connected to node N6.

The transient biasing circuit block 162 includes: diode D2r having its anode connected to supply voltage VDD; diode D1r having its anode connected to the cathode of D2r; n-channel transistor M8 having it drain connected to the cathode of D1r, its source and body connected to node N6, and its gate connected to node N2, with voltage FGREP being generated at node N6; n-channel transistor M4 having its drain connected to node N6, its source connected to ground, and its gate connected to node N1; p-channel transistor M10 having its source connected to supply voltage VDD, its drain connected to node N7, and its gate connected to node N7; n-channel transistor M9 having its drain connected to node N7 and its gate connected to node N2; n-channel transistor M5 having its drain connected to the source of transistor M9, its source connected to ground, and its gate connected to node N1; p-channel transistor M11 having its source connected to supply voltage VDD and its gate connected to the gate of M10 and node N7; p-channel transistor M12 having its source connected to the drain of transistor M11, its drain connected to node N8, and its gate connected to node N6; resistor R3 connected between nodes N8 and N9; and n-channel transistor M13 having its drain connected to node N9, its source connected to node N6, and its gate connected to node N8.

The floating ground generation circuit 150' operates through the coordinated action of the core biasing circuit block 160, the driver logic circuit block 161, and the transient biasing circuit block 162. In the core biasing circuit block 160, two reference voltages are generated to establish the operating conditions for the entire floating ground generation circuit 150'. At node N1, resistors R1 and R2 form a voltage divider between the supply voltage VDD and ground, producing a reference voltage VTH. Transistor M1 is configured in a diode-connected arrangement to establish a reference current through the voltage divider. The voltage VTH at node N1 biases the gates of transistors M2, M4, and M5 in their respective branches, setting their operating points within the circuit.

In parallel, a second reference voltage VN2 is generated at node N2 through resistor Rth and transistor M6. Transistor M6, an n-channel transistor with its source and body connected together, is also configured in a diode-connected arrangement. This arrangement establishes a threshold-dependent voltage at node N2 that tracks with process and temperature variations. The voltage at node N2 sets the operating point for transistors M7, M8, and M9.

The interaction between these two reference voltages VTH and VN2 is managed through transistors M2 and M14. Transistor M2 modulates the current flowing through transistor M14. Transistor M14 establishes the bias voltage at node N3. The voltage at node N3 influences the operation of subsequent stages by providing biasing conditions through the gate of transistor MT1 in the driver logic circuit block 161.

In the driver logic circuit block 161, the intermediate voltage FGX is generated at node N4 through a complementary pair of transistors M16 and M15. Transistor M16 defines the branch bias current, and transistor M15 provides cascode protection to the underlying transistors. The signal FSREP, received from the floating supply generation circuit 152', controls transistor M15 for synchronizing the operation of the floating ground generation circuit 150' with the floating supply voltage levels. The signal FSREP ensures M15 switches at the appropriate moments, allowing the voltage FGX at node N4 to adjust correspondingly.

The output at node N4 drives the gate of transistor M3, which functions as a pull-down device for node N5 when node N4 is high, contributing to voltage control at node N5. This is enhanced by transistor M7, an n-channel transistor with its source and body connected to node N5. Transistor M7 level-shifts the voltage between nodes N4 and N5 based on the reference voltage from node N2. As a result, the floating gate voltage VFG is generated at node N5, which is the main output of the floating ground generation circuit 150'.

The relationship between FGX and VFG is that FGX controls the gate of transistor M3, which in turn affects the voltage at node N5 (FG). Transistor M7 acts as a level shifter between FGX and FG, ensuring that VFG follows the desired voltage levels dictated by FGX and the reference voltage VN2.

The improved output impedance of the generated floating ground voltage VFG is achieved by this configuration, reducing it from 1/gm7 to 1/((1 + gm7·ro7)·gm3), where gm7 is the transconductance of transistor M7, ro7 is the output resistance of M7, and gm3 is the transconductance of transistor M3, which improves the settling time of the floating ground and its driving capability.

To provide for stability of the loop formed by transistors M3 and M7, a compensation MOS capacitor (moscap) is added at the source of transistor M15 with respect to the source of transistor M3 - capacitor Cc, connected between node N4 and ground, filters high-frequency noise and improves stability during switching transitions. Capacitor Cd, connected between supply voltage VDD and node N5, provides additional high-frequency decoupling to stabilize the output during fast transients.

A transient response circuit within the driver logic circuit block 161 comprises transistors MT1, MT2, and MT3. Transistor MT1 provides a discharge path from node N5 to ground when activated by the voltage at node N3. Transistor MT2 adjusts the current path from node N5 to ground based on the voltage at node N6, influencing the floating ground voltage VFG at node N5. The voltage FGREP at node N6, generated by the transient biasing block 162, controls the gate of MT2. The interaction between FGREP and FSREP is as follows - while FSREP determines the timing of M15 in the driver logic block 161, FGREP adjusts MT2 to fine-tune the discharge of node N5 during transitions.

Transistor MT3 connects node N5 to the supply voltage VDD for voltage pulling operations controlled by node N9.

The transient biasing circuit block 162 controls the floating ground voltage VFG during rapid transitions through three main paths. The primary path generates the signal FGREP at node N6 through diodes D2r and D1r. Transistor M8, an n-channel transistor with its source and body connected to node N6, controls the current flow to node N6 based on the reference voltage at node N2. Transistor M4 establishes a ground-referenced current path, maintaining node N6 within its operating range.

A second control path involves transistors M9, M5, and M10. Transistor M10 forms a diode-connected configuration at node N7. Transistor M9 operates in conjunction with transistor M5 to control current flow based on the voltage at node N1. This arrangement monitors operating state and adjusts the voltage at node N7 accordingly. The voltage at node N7 influences the gate of transistor M16 in the driver logic circuit block 161, affecting how VDD is connected to the intermediate voltage FGX at node N4, coordinating with signals FSREP and FGREP during transitions.

A third path forms a feedback loop involving transistors M11, M12, M13, and resistor R3. Transistor M11 forms another diode-connected configuration controlled by the voltage at node N7. Transistor M12 senses the FGREP voltage at node N6 and adjusts the control voltage at node N8. Resistor R3, connected between nodes N8 and N9, limits the feedback current and sets the loop response time, and transistor M13 regulates current flow between nodes N9 and N6 based on the voltage at node N8.

During transients, these three paths work together to adjust signal FGREP at node N6. Changes in signal FGREP influence the gate voltage of transistor MT2 in the driver logic block 161, modulating the current path from node N5 to ground. This modulation is synchronized with the signal FSREP controlling transistor M15, ensuring that the floating gate voltage VFG at node N5 adjusts smoothly during transitions. The relative timing between signals FSREP and FGREP is of interest - FSREP initiates the transition by controlling transistor M15, while signal FGREP fine-tunes the response by adjusting transistor MT2, allowing handling of rapid changes without introducing voltage spikes or glitches.

This interaction helps maintain stable floating ground operation during voltage variations. The diode-transistor cascade involving diodes D2r and D1r and transistor M8 ensures that signal FGREP tracks supply voltage VDD variations while maintaining proper voltage stress limits across the devices. By dynamically adjusting the biasing conditions based on the reference voltages at nodes N1 and N2 and utilizing feedback mechanisms through nodes N6, N8, and N9, the circuit effectively manages rapid transitions and maintains operational stability.

The coordination between the core biasing circuit block 160, the driver logic circuit block 161, and the transient biasing circuit block 162 ensures that the floating ground generation circuit 150' provides a stable floating gate voltage VFG at node N5. Signal FSREP, originating from the floating supply generation circuit 152', provides the initial control signal for timing the switching events, while signal FGREP provides real-time feedback to adjust the response during these events. This allows for precise control over the floating gate voltage levels and timing, ensuring that the SMPS 100 operates reliably even under varying load conditions and supply voltage fluctuations.

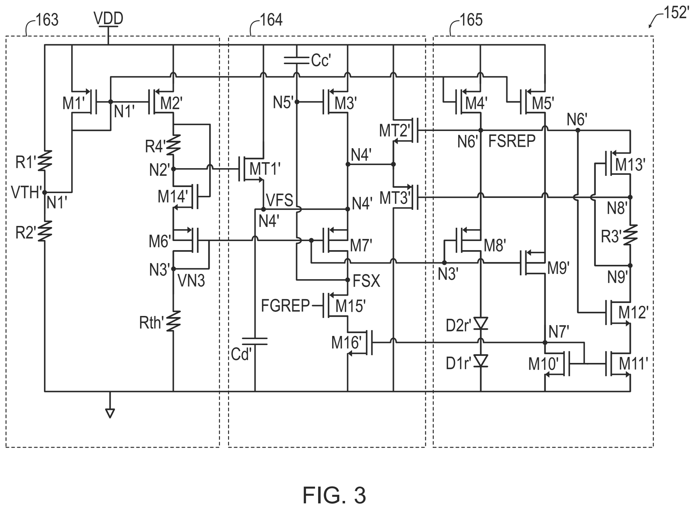

The floating supply generation circuit 152' is now described with reference to Figure 3. The core biasing block 163 in the floating supply generation circuit 152' includes: resistor R1' connected between VDD and node N1'; resistor R2' connected between node N1' and ground, with voltage VTH' being formed at node N1'; p-channel transistor M1' having its source connected to VDD, its drain connected to node N1', and its gate connected to node N1'; p-channel transistor M2' having its source connected to VDD and its gate connected to node N1'; resistor R4' connected between the drain of transistor M2' and node N2'; n-channel transistor M14' having its drain connected to node N2' and its gate connected to the drain of transistor M2'; p-channel transistor M6' having its source and body connected to the source of transistor M14', its drain connected to node N3', and its gate connected to node N3', with a voltage VN3 being generated at node N3'; and resistor Rth' connected between node N3' and ground.

The driver logic block 164 in the floating supply generation circuit 152' includes: n-channel transistor MT1 having its drain connected to VDD, its source connected to node N4', and its gate connected to node N2'; capacitor Cd' connected between node N4' and ground; capacitor Cc' connected between VDD and node N5', with voltage FSX being generated at node N5'; p-channel transistor M3' having its source connected to VDD, its drain connected to node N4', and its gate connected to node N5'; p-channel transistor M7' having its source and body connected to node N4', its drain connected to node N5', and its gate connected to node N3'; p-channel transistor M15' having its source connected to node N5' and its gate coupled to receive the voltage FGREP; n-channel transistor M16' having its drain connected to the drain of M15', its source connected to ground, and its gate connected to node N7'; n-channel transistor MT2' having its drain connected to VDD, its source connected to node N4', and its gate connected to node N6', with voltage FSREP being formed at node N6'; and p-channel transistor MT3' having its source connected to node N4', its drain connected to ground, and its gate connected to node N8'.

The transient biasing logic block 165 in the floating supply generation circuit 152' includes: p-channel transistor M4' having its source connected to VDD, its drain connected to node N6', and its gate connected to node N1'; p-channel transistor M8' having its source and body connected to node N6' and its gate connected to node N'; diode D2r' having its anode connected to the drain of transistor M8'; diode D1r' having its anode connected to the cathode of D2r' and its cathode connected to ground; p-channel transistor M5' having its source connected to VDD and its gate connected to node N1'; p-channel transistor M9' having its source and body connected to the drain of transistor M5', its drain connected to node N7', and its gate connected to node N3'; n-channel transistor M10' having its drain connected to node N7', its gate connected to node N7', and its source connected to ground; p-channel transistor M13' having its source connected to node N6', its drain connected to node N8', and its gate connected to node N9'; resistor R3' connected between node N8' and node N9'; n-channel transistor M12' having its drain connected to node N9' and its gate connected to node N6'; and n-channel transistor M11' having its drain connected to the source of M12', its source connected to ground, and its gate connected to the gate of M10'.

The floating supply generation circuit 152' operates through the coordinated action of the core biasing block 163, the driver logic block 164, and the transient biasing logic block 165. In the core biasing block 163, two reference voltages are generated to establish the operating conditions for the entire floating supply circuit. At node N1', resistors R1' and R2' form a voltage divider between the supply voltage VDD and ground, producing a reference voltage VTH'. Transistor M1' is configured in a diode-connected arrangement. This configuration establishes a reference current through the voltage divider, helping to set the voltage at node N1'. The voltage at node N1' biases the gates of transistors M2' and M5', setting their operating points within the circuit.

In parallel, a second reference voltage is generated at node N3' through resistor Rth' and transistor M6'. Transistor M6', a p-channel transistor with its source and body connected to the source of transistor M14', is configured in a diode-connected arrangement. This establishes a threshold-dependent voltage VN3 at node N3' that tracks with process and temperature variations. The voltage VN3 sets the operating point for transistors M7' and M9'.

The interaction between these two reference voltages VTH' and VN3 is managed through transistors M2' and M14'. Transistor M2' modulates the current flowing through resistor R4', which is connected between the drain of M2' and node N2'. Transistor M14' modulates the current flowing into node N2', establishing the bias voltage at node N2'. The voltage at node N2' influences the operation of the driver logic block 164 by controlling transistors MT1' and M3'.

In the driver logic block 164, the floating supply voltage VFS is generated at node N5' through a complementary pair of transistors M3' and M7'. Transistor M3' and transistor M7', a p-channel transistor with its source and body connected to node N4' form a configuration that buffers the floating supply voltage. This configuration improves the output impedance of the generated floating rail from 1/gm7' to 1/((1 + gm7'·ro7')·gm3'), enhancing the settling time of the floating supply voltage and its driving capability.

To ensure the stability of the loop formed by transistors M3' and M7', a compensation MOS capacitor, Cc', is added at the source of transistor M15' with respect to the source of transistor M3'. The output at node N5' serves as the floating supply voltage FS, which is used to drive subsequent stages. The floating supply voltage VFS is directly related to the floating ground voltage VFG generated by the floating ground generation circuit 150'. VFS provides the high-side supply voltage for the floating circuits, whereas VFG serves as the reference ground for these circuits. The coordination between VFS and VFG ensures that the high-side driver operates correctly, with VFS being elevated above VFG by the required gate-source voltage levels.

Transistor MT1' functions as a current source controlled by the voltage at node N2'. Capacitor Cd', connected between node N4' and ground, filters high-frequency noise and improves stability during switching transitions. Capacitor Cc', serving as the compensation capacitor, ensures the stability of the feedback loop by compensating the phase margin, thus preventing oscillations in the loop formed by transistors M3' and M7'.

The transient response of the driver logic block 164 is managed by transistors M15', M16', MT2', and MT3'. Transistor M15' provides cascode protection to the underlying transistors by shielding them from voltage variations at node N5'. Transistor M16' defines the branch bias current for this stage. This configuration allows for the modulation of the floating supply voltage VFS during transitions, controlled by the voltage FGREP from the floating ground generation circuit 150'. The voltage FGREP, acting as a control signal from the floating ground circuit, ensures that VFS transitions are synchronized with the floating ground voltage levels, maintaining the correct voltage difference between VFS and FG.

Transistor MT2' adjusts the current path into node N4' based on the voltage at node N6'. Transistor MT3' provides a discharge path from node N4' to ground when activated by the voltage at node N8'.

The transient biasing logic block 165 controls the floating supply voltage during rapid transitions through three main paths. The primary path generates the FSREP signal at node N6' through transistors M4' and M8', and diodes D2r' and D1r'. Transistor M4' controls the current flow into node N6' based on the reference voltage at node N1'. Transistor M8', a p-channel transistor with its source and body connected to node N6', further modulates the current into node N6'. The diodes D2r' and D1r', with diode D2r' having its anode connected to the drain of M8' and diode D1r' having its anode connected to the cathode of D2r' and its cathode connected to ground, provide voltage level shifting and help maintain proper voltage levels at node N6'.

A second control path involves transistors M5', M9', and M10'. Transistor M5' provides current to the source of transistor M9'. Transistor M9', a p-channel transistor with its source and body connected to the drain of M5', operates in conjunction with transistor M10'. This arrangement monitors the circuit's operating state and adjusts the voltage at node N7' accordingly. The voltage at node N7' influences the gate of transistor M16' in the driver logic block 164, affecting how the floating supply voltage VFS is connected to ground through M16', thereby coordinating with FGREP and FSREP during transitions.

A third path forms a feedback loop involving transistors M13', M12', M11', and resistor R3'. Transistor M13' provides a current path controlled by the voltage at node N9'. Resistor R3', connected between nodes N8' and N9', limits the feedback current and sets the loop response time. Transistor M12', an n-channel transistor with its drain connected to node N9' and its gate connected to node N6', and transistor M11' complete the feedback loop. This loop adjusts the voltage at node N8', which controls the gate of transistor MT3' in the driver logic block 164, providing fine-tuning of the floating supply voltage during transitions.

During voltage transients, these three paths work together to adjust FSREP at node N6'. Changes in FSREP influence the gate voltage of transistor MT2' in the driver logic block 164, modulating the current path from VDD into node N4'. This modulation is synchronized with the voltage FGREP controlling transistor M15', ensuring that the floating supply voltage VFS at node N5' adjusts smoothly during transitions. The relative timing between FGREP and FSREP is crucial; FGREP, originating from the floating ground generation circuit 150', provides a control signal that ensures coordinated operation between the floating ground and floating supply circuits. FSREP, generated internally within the floating supply generation circuit 152', provides local feedback to adjust the circuit's response during these events. Their combined effect allows for precise control over the floating supply voltage FS, maintaining the necessary voltage differential with the floating ground voltage FG, and ensuring that the SMPS 100 operates reliably even under varying load conditions and supply voltage fluctuations.

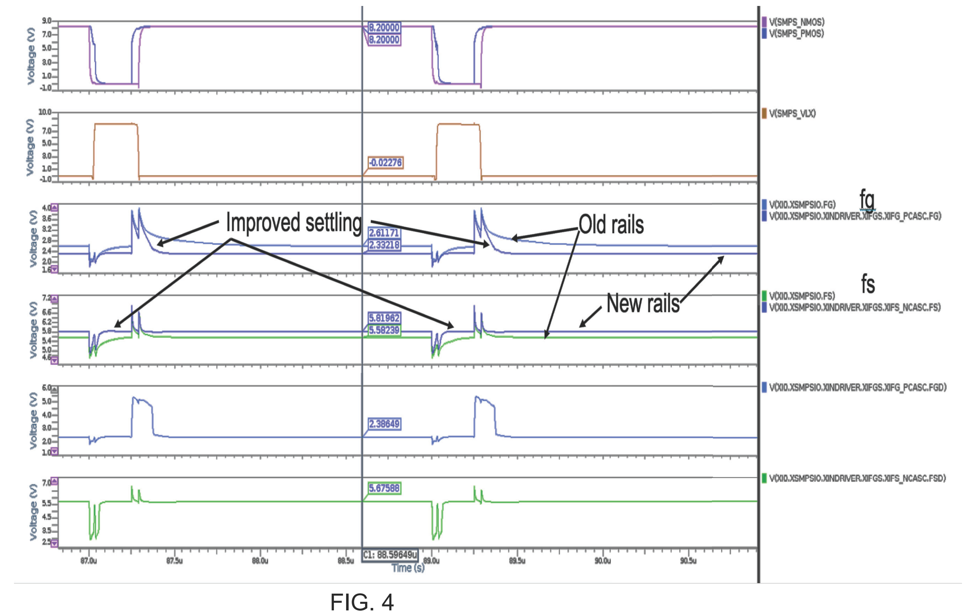

The floating ground and source generation circuits 150' and 152' provide several advantages for SMPS operation. The design achieves improved efficiency and noise isolation for analog components through its floating rail (floating supply and floating ground) architecture, while eliminating the need for separate reference voltage generation circuits. The open-loop operation of the floating rails enables stable high-speed operation across a wide range of load and line variations. As demonstrated by the waveforms of Figure 4, the settling time is significantly improved compared to previous implementations, enabling higher operating frequencies. Additionally, the high-voltage tolerance of the design reduces overall mask costs in fabrication. These improvements are achieved while maintaining precise control over voltage levels and timing, providing for reliable SMPS operation under varying conditions.

The careful coordination between the core biasing block 163, the driver logic block 164, and the transient biasing logic block 165 ensures that the floating supply generation circuit 152' provides a stable floating supply voltage FS. The reference voltages at nodes N1' and N3' establish the operating points for critical transistors, while the transient biasing mechanisms adjust the circuit's response during voltage variations. By dynamically adjusting the biasing conditions based on these reference voltages and utilizing feedback mechanisms through nodes N6', N7', and N8', the circuit effectively manages rapid transitions and maintains operational stability.

This design allows for reliable operation of the switching mode power supply (SMPS) 100, accommodating changes in supply voltage VDD and maintaining consistent performance across different operating conditions. The integration of the floating supply generation circuit 152' with the floating ground generation circuit 150' ensures that both the high-side and low-side drivers in the SMPS are properly biased, enabling efficient and stable power conversion. The relationship between VFS and VFG is critical; VFS serves as the supply voltage for the high-side driver circuits relative to the floating ground VFG, and the precise control of their voltage levels and timing ensures that the transistors in the high-side driver operate within their safe operating area, preventing latch-up and improving the overall reliability of the SMPS 100.

The waveforms shown in Figure 4 demonstrate the improved performance of the floating ground 150' and floating supply 151' generation circuits compared to the prior art. Specifically, when transitioning between voltage levels, the VFG and VFS show significantly reduced settling time and fewer oscillations compared to the old rails, with the overshoot and ringing being notably diminished. The relative timing between VFG and VFS transitions is well-coordinated, with VFG operating around 2.5V and VFS around 5.5V, maintaining an appropriate voltage differential for proper high-side driver operation.

Finally, it is evident that modifications and variations can be made to what has been described and illustrated herein without departing from the scope of this disclosure.

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

## Claims

1. A floating ground generation circuit (150'), comprising:
a core biasing circuit (160) configured to generate first and second reference voltages (VTH, VN2);
a driver logic circuit (161) coupled to the core biasing circuit (160) and configured to generate a floating ground voltage (VFG) based on the first and second reference voltages (VTH, VN2); and
a transient biasing circuit (162) coupled to the driver logic circuit (161) and configured to control transitions of the floating ground voltage (VFG) between voltage levels,
wherein:
- the driver logic circuit (161) is configured to receive a floating supply reference signal (FSREP), and
the transient biasing circuit (162) is configured to generate a floating ground reference signal (FGREP),
the floating supply reference signal (FSREP) and the floating ground reference signal (FGREP) being coordinated to control timing of the transitions between voltage levels.

2. The floating ground generation circuit (150') of claim 1, wherein the core biasing circuit (160) comprises:
a voltage divider (R1, R2) coupled between a supply voltage (VDD) and ground to generate the first reference voltage (VTH); and
a threshold voltage generator coupled to the supply voltage (VDD) to generate the second reference voltage (VN2) that tracks process and temperature variations.

3. The floating ground generation circuit (150') of claim 2, wherein:
- the voltage divider comprises a first resistor (R1) connected between the supply voltage (VDD) and a first node (N1); and a second resistor (R2) connected between the first node (N1) and ground, wherein the first reference voltage (VTH) is generated at the first node (N1); and/or
- the threshold voltage generator comprises a third resistor (Rth) connected between the supply voltage (VDD) and a second node (N2); and an n-channel transistor (M6) having its drain and gate connected to the second node (N2), and its body connected to its source, wherein the second reference voltage (VN2) is generated at the second node (N2).

4. The floating ground generation circuit (150') of claim 1, wherein the driver logic circuit (161) comprises:
a level shifting circuit configured to generate an intermediate voltage;
a floating ground output circuit coupled to the level shifting circuit and configured to generate the floating ground voltage (VFG) based on the intermediate voltage; and
a transient response circuit configured to control discharge paths for the floating ground voltage (VFG).

5. The floating ground generation circuit (150') of claim 4, wherein:
- the floating ground output circuit comprises a level-shifting transistor having its gate coupled to receive the second reference voltage and configured to level-shift between the intermediate voltage and the floating ground voltage; and a pull-down transistor having its gate coupled to receive the intermediate voltage and configured to control the floating ground voltage, and/or
the driver logic circuit (161) further comprises a first capacitor (Cd) connected between a node carrying the intermediate voltage and ground to filter high-frequency noise; and a second capacitor (Cc) connected between a supply voltage (VDD) and a node carrying the floating ground voltage (VFG) to provide high-frequency decoupling.

6. The floating ground generation circuit (150') of claim 1, wherein the transient biasing circuit comprises: a diode-transistor cascade circuit configured to generate the floating ground reference signal that tracks supply voltage variations while maintaining voltage stress limits; a first control path configured to monitor operating state and adjust bias conditions; and a feedback loop configured to regulate current flow during transitions, preferably wherein the diode-transistor cascade circuit comprises: a first diode having an anode connected to the supply voltage; a second diode having an anode connected to a cathode of the first diode; and a transistor having its drain connected to a cathode of the second diode and its gate coupled to receive the second reference voltage.

7. The floating ground generation circuit (150') of claim 1, wherein the driver logic block (161) includes compensation circuitry configured to improve output impedance and settling time of the floating ground voltage.

8. A floating supply voltage generation circuit (152'), comprising:
a core biasing block (163) configured to generate first and second reference voltages (VTH', VN3);
a driver logic block (164) coupled to the core biasing block (163) and configured to generate a floating supply voltage (VFS) based on the first and second reference voltages (VTH', VN3); and
a transient biasing block (165) coupled to the driver logic block (164) and configured to control transitions of the floating supply voltage (VFS) between voltage levels,
wherein:
- the driver logic block (164) is configured to receive a floating ground reference signal (FGREP), and
- the transient biasing block (165) is configured to generate a floating supply reference signal (FSREP),
- the floating ground reference signal (FGREP) and floating supply reference signal (FSREP) being coordinated to control timing of the transitions between voltage levels.

9. The floating supply voltage generation circuit (152') of claim 8, wherein the core biasing block (163) comprises: a voltage divider coupled between a supply voltage and ground to generate the first reference voltage; and a threshold voltage generator coupled to the supply voltage to generate the second reference voltage that tracks process and temperature variations.

10. The floating supply voltage generation circuit (152') of claim 9, wherein the voltage divider comprises: a first resistor connected between the supply voltage and a first node; and a second resistor connected between the first node and ground, wherein the first reference voltage is generated at the first node.

11. The floating supply voltage generation circuit (152') of claim 9, wherein:
- the threshold voltage generator comprises: a resistor connected between a third node and ground; a p-channel transistor having its source and body connected to a source of a transistor, its drain and gate connected to the third node, wherein the second reference voltage is generated at the third node, and/or the driver logic block comprises: a level shifting circuit configured to generate an intermediate voltage; a floating supply output circuit coupled to the level shifting circuit and configured to generate the floating supply voltage based on the intermediate voltage; and a transient response circuit configured to control charging paths for the floating supply voltage.

12. The floating supply voltage generation circuit (152') of claim 1, wherein the floating supply output circuit comprises: a level-shifting transistor having its source and body connected to a node carrying an intermediate voltage and its gate coupled to receive the second reference voltage; and a pull-up transistor having its source connected to the supply voltage, its gate coupled to receive the intermediate voltage, and configured to control the floating supply voltage, preferably wherein the driver logic block further comprises: a first capacitor connected between a node carrying the intermediate voltage and ground to filter high-frequency noise; and a second capacitor connected between the supply voltage and a node carrying the floating supply voltage for compensation.

13. The floating supply voltage generation circuit of claim 8, wherein the transient biasing block comprises: a diode-transistor cascade circuit configured to generate the floating supply reference signal that tracks supply voltage variations while maintaining voltage stress limits; a first control path configured to monitor operating state and adjust bias conditions; and a feedback loop configured to regulate current flow during transitions, preferably wherein the diode-transistor cascade circuit comprises: a first diode having its anode connected to a drain of a transistor; a second diode having its anode connected to a cathode of the first diode and its cathode connected to ground; and a p-channel transistor having its source and body connected to a node carrying the floating supply reference signal and its gate coupled to receive the second reference voltage.

14. The floating supply voltage generation circuit of claim 8, wherein the driver logic block includes compensation circuitry configured to improve output impedance and settling time of the floating supply voltage.

15. A DC-DC converter system, comprising:
a switching circuit configured to transfer power between an input and an output; and
a floating reference generation circuit configured to provide a floating reference voltage to the switching circuit, the floating reference generation circuit comprising:
a core biasing block configured to generate first and second reference voltages;
a driver logic block coupled to the core biasing block and configured to generate the floating reference voltage based on the first and second reference voltages; and
a transient biasing block coupled to the driver logic block and configured to control transitions of the floating reference voltage between voltage levels, wherein the driver logic block is configured to receive a complementary reference signal and the transient biasing block is configured to generate a local reference signal, the complementary reference signal and local reference signal being coordinated to control timing of the transitions between voltage levels.

16. The DC-DC converter system of claim 15, wherein the floating reference voltage comprises one of: a floating ground voltage for referencing a low-side of the switching circuit; or a floating supply voltage for referencing a high-side of the switching circuit.

17. The DC-DC converter system of claim 15, wherein the core biasing block comprises: a voltage divider coupled between a supply voltage and ground to generate the first reference voltage; and a threshold voltage generator coupled to the supply voltage to generate the second reference voltage that tracks process and temperature variations.

18. The DC-DC converter system of claim 15, wherein:
- the voltage divider comprises: a first resistor connected between the supply voltage and a first node; and a second resistor connected between the first node and ground, wherein the first reference voltage is generated at the first node, and/or
- the threshold voltage generator comprises: a reference resistor connected between one of: the supply voltage and a reference node, or the reference node and ground; and a threshold transistor having its control terminal and first current terminal connected to the reference node, wherein the second reference voltage is generated at the reference node.

19. The DC-DC converter system of claim 15, wherein the driver logic block comprises: a level shifting circuit configured to generate an intermediate voltage; an output circuit coupled to the level shifting circuit and configured to generate the floating reference voltage based on the intermediate voltage; and a transient response circuit configured to control current paths between the floating reference voltage and a fixed reference.

20. The DC-DC converter system of claim 19, wherein the output circuit comprises: a level-shifting transistor having its control terminal coupled to receive the second reference voltage and configured to level-shift between the intermediate voltage and the floating reference voltage; and a control transistor having its control terminal coupled to receive the intermediate voltage and configured to control the floating reference voltage.

21. The DC-DC converter system of claim 19, wherein the driver logic block further comprises: a first capacitor connected between a node carrying the intermediate voltage and a fixed reference to filter high-frequency noise; and a second capacitor connected between the supply voltage and a node carrying the floating reference voltage to provide compensation.

22. The DC-DC converter system of claim 15, wherein the transient biasing block comprises: a diode-transistor cascade circuit configured to generate the local reference signal that tracks supply voltage variations while maintaining voltage stress limits; a first control path configured to monitor operating state and adjust bias conditions; and a feedback loop configured to regulate current flow during transitions, preferably wherein the diode-transistor cascade circuit comprises: a first diode coupled to the supply voltage; a second diode coupled to the first diode; and a cascade transistor coupled between the second diode and a node carrying the local reference signal, the cascade transistor having its control terminal coupled to receive the second reference voltage.

23. The DC-DC converter system of claim 15, wherein the floating reference generation circuit is implemented as a floating ground generation circuit with the floating reference voltage comprising a floating ground voltage, and wherein the complementary reference signal comprises a floating supply reference signal.

24. The DC-DC converter system of claim 15, wherein the floating reference generation circuit is implemented as a floating supply generation circuit with the floating reference voltage comprising a floating supply voltage, and wherein the complementary reference signal comprises a floating ground reference signal.
